# EUROPEAN PATENT SPECIFICATION

(11) **EP 1 814 067 B1**
(45) Date of publication and mention of the grant of the patent: **13.08.2008**
(21) Application number: 06122184.2
(22) Date of filing: 12.10.2006
(51) Int. Cl.: G06K 19/077

(54) **Method of reeling a series of RFID tags and RFID tag roll**
Verfahren zum Aufrollen einer RFID-Etikettserie und RFID-Etikettrolle
Procédé de bobinage d'une série d'étiquettes RFID et rouleau d'étiquettes RFID

(30) Priority: 31.01.2006 JP 2006022360
(43) Date of publication of application: 01.08.2007
(73) Proprietor: FUJITSU LIMITED, Kawasaki-shi, Kanagawa 211-8588 (JP); Fujitsu Frontech Limited, Inagi-shi, Tokyo 206-8555 (JP)
(72) Inventor: Ishikawa, Naoki, c/o Fujitsu Limited, Kawasaki-shi Kanagawa 211-8588 (JP); Tsuneno, Tatsuro, c/o Fujitsu Frontech Limited, Inagi-shi Tokyo 206-8555 (JP); Kira, Hidehiko, c/o Fujitsu Limited, Kawasaki-shi Kanagawa 211-8588 (JP)
(74) Representative: Kreutzer, Ulrich

(56) References cited:
- WO-A-01/03188
- WO-A-20/04097726
- US-A- 6 140 146
- US-A1- 2006 011 288

## Description

### BACKGROUND OF THE INVENTION

### Field of the Invention

The present invention relates to a method of reeling a series of RFID tags and an RFID tag roll. On the series of RFID tags are formed plural RFID (Radio_frequency_IDentification) tags which exchange information with an external device without contacting the device and are disposed in a predetermined pitch on a long-belt-like and flexible base. The RFID tag roll is reeled up with the series of RFID tags. Among people skilled in the field of the art, an "RFID tag" used in the invention is also called as an "inlay for RFID tag", an inlay which is an internal component of an "RFID tag". This "RFID tag" is also called as a "wireless IC tag". The RFID tag includes a noncontact IC card.

### Description of the Related Art

In recent years have been proposed various RFID tags which exchange information with an external device typified by a reader and a writer using a radio wave without contacting the device (for example, see Japanese Patent Laid-Open Nos. 2000-311226, 2000-200332 and 2001-351082). One such RFID tag is provided with an antenna pattern for radio communication and a circuit chip both mounted on a base sheet made of a plastic or paper. The applications of such an RFID tag are discrimination of an article and the like to which the RFID tag is attached to by exchanging information about the article and the like with an external device.

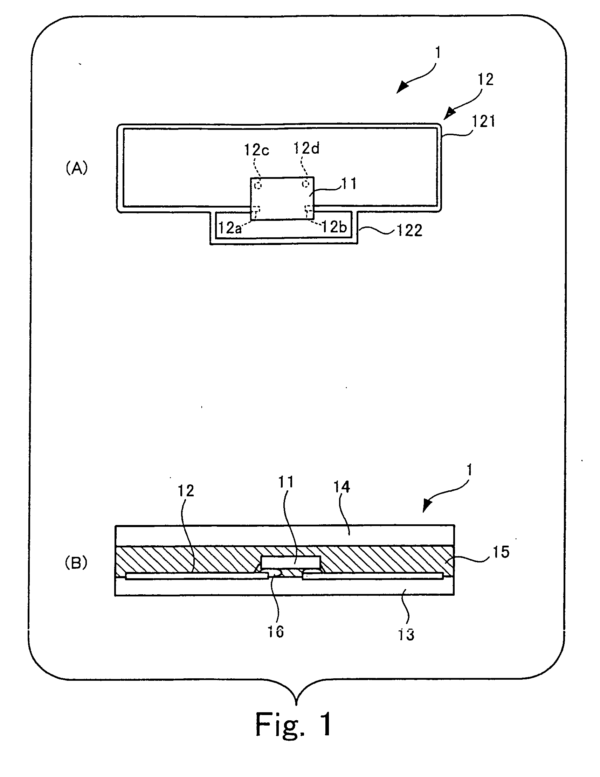

Part (A) and part (B) of Fig. 1 are respectively a front view and a side cross section both showing an example of RFID tag.

An RFID tag 1 shown in Fig. 1 is composed of an antenna 12 that is formed with a conductive material (such as Cu or Al or Ag paste) and disposed on a base 13 in a thin film form made of PET, polyimid and the like, an IC chip 11 with IC electrodes connected through bumps 16 to the antenna 12, a cover sheet 14 glued to the base 13 by an adhesive agent 15 such that the cover sheet 14 covers the antenna 12 and the IC chip 11.

At this point, the electrodes of the IC chip 11 are glued at four points of two ends 12a and 12b of the antenna 12 and two lands 12c and 12d both formed separated from the antenna on the base 13. Only the two electrodes connected to the ends 12a and 12b of the antenna 12 perform electrical effects actually, while other electrodes connected to the lands 12c and 12d are simply for fixing the IC chip stably on the base 13.

The IC chip 11 composing the RFID tag 1 may perform radio communication with external devices with the antenna 12 to exchange information.

Further, in Fig. 1, the antenna 12 of the RFID tag 1 is composed of two loops 121 and 122. However, the antenna 12 is not so limited to this form. Other antennas with various forms such as one formed in a loop and one in a bar form extended from the both sides of the IC chip may be applied.

Next, a manufacturing process of the RFID tag 1 shown in Fig. 1 will be described.

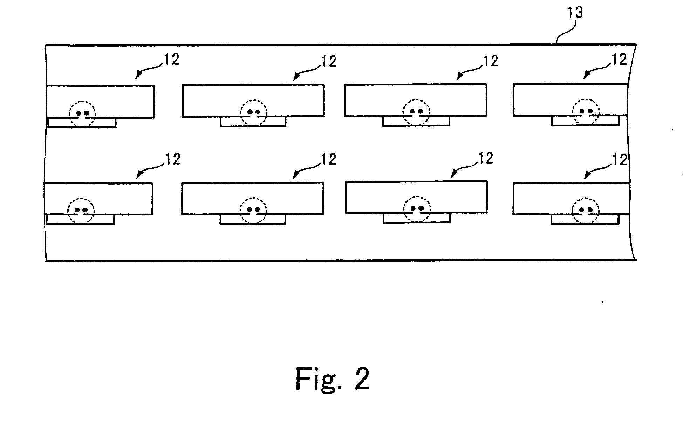

Fig. 2 is a diagram showing a state where the antenna is formed on the base.

In this example, a base 113 is prepared which is in a long-belt-like form extending in the right and left directions in Fig. 2, and which is flexible and in a thin film form made of PET or polyimid, for example. On the base 13, a number of the antennas 12 for the RFID tag are formed with a predetermined pitch using a conductive material such as Ag paste.

Next, on each antenna 12, a respective IC chip (see Fig. 1) is mounted at a position indicated by circles in dotted lines in Fig. 2.

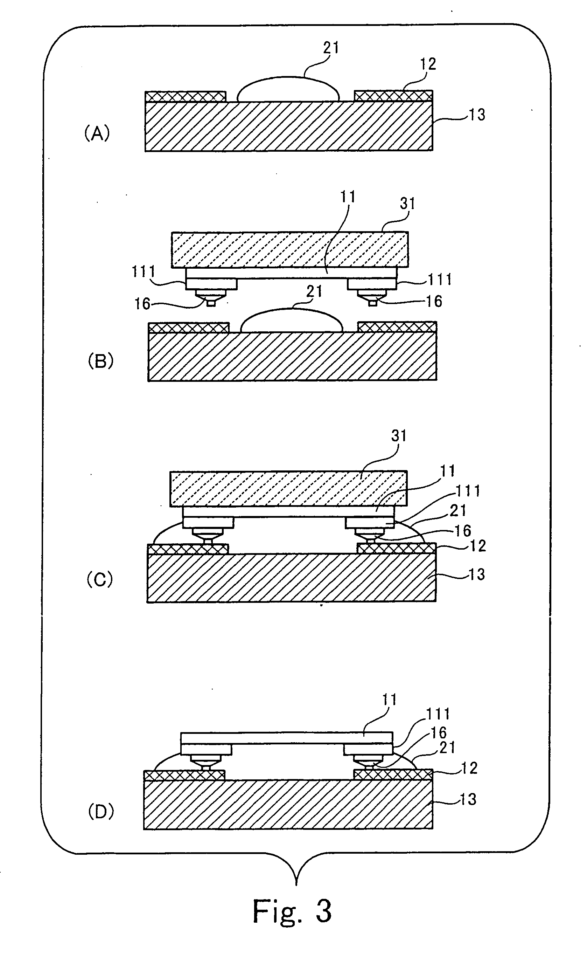

Fig. 3 is a process chart showing an IC chip mounting process.

A thermosetting adhesive agent 21 is applied on the IC mount position (indicated by the circles in dotted lines in Fig. 2) on the base 13 on which the antenna 12 is formed as shown in part (A) of Fig. 3.

Next, the IC chip 11 with solder bumps 16 formed on the IC electrodes 111 is carried and placed in registration with the IC mount position on the base 13 (part (B) of Fig. 3). Then the IC chip 11 is pressed on the base 13 by a mounting head 31 and is simultaneously heated (part (C) of Fig. 3). In this manner, the IC chip 11 is glued by solder to the antenna 12 with the bump 16 and is glued on the base 13 with hardening of the adhesive agent, and then the mounting head 31 is removed (part (D) of Fig. 3).

As shown in Fig. 2, for each of a number of the antennas 12 formed on the base 13, the IC chip mount process mentioned above is repeated.

After the IC chip 11 is mounted as shown above, the IC chip is covered with the cover sheet 14 as necessary. (see part (B) of Fig. 1).

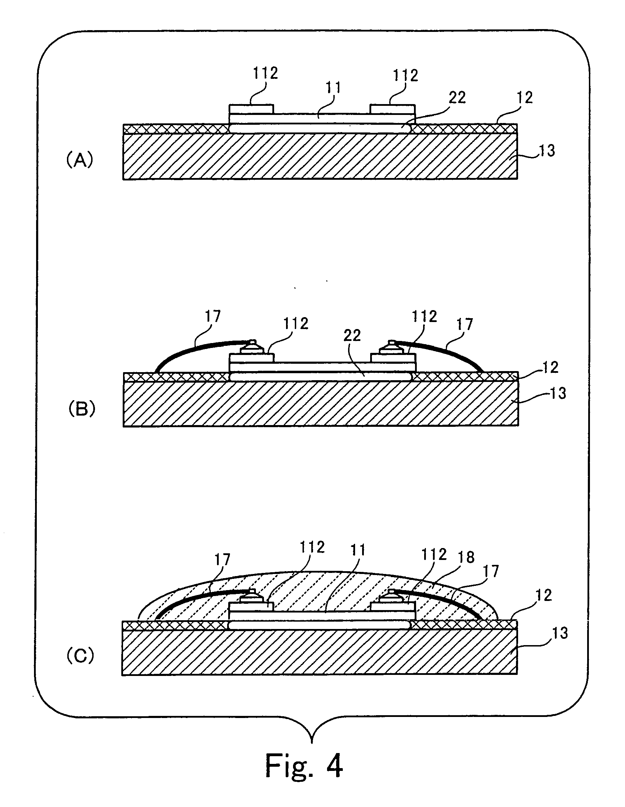

Fig. 4 is a process chart showing another IC chip mounting process.

A thermosetting adhesive agent 22 is applied on the IC mount position (indicated by circles in dotted lines in Fig. 2) on the base 13 on which the antenna 12 is formed. The IC chip 11 is mounted at the IC mount position and glued on the base 13 by an adhesive agent 22 with the electrode 112 directed upwardly (part (A) of Fig. 4).

Next, the electrodes 112 of the IC chip 11 and the antennas 12 on the base 13 are wire-bonded with bonding wires 17(part (B) of Fig. 4) and then are encapsulated by a resin 18 (part (C) of Fig. 4).

An assembly with IC chips mounted on respective antennas 12 as shown in Fig. 3 or Fig. 4 is called a series RFID tags.

The series of RFID tags is rolled to be sent to manufacturing processes such as separating each of the RFID tags to be mounted on an IC card.

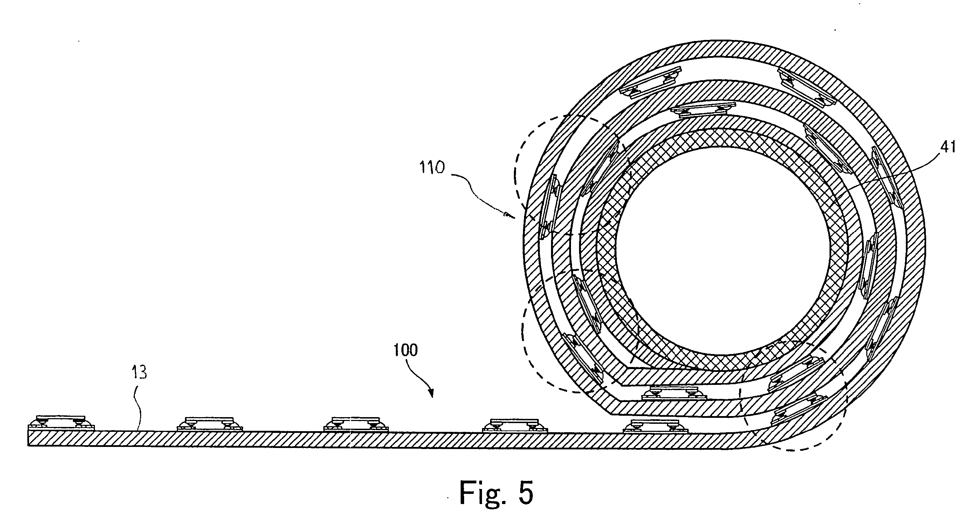

Fig. 5 is a diagram showing an RFID tag roll that the series of RFID tags is reeled.

A series RFID tags 100 that includes a number of the RFID tags formed on the base 13 having a long-belt-like form is reeled around a cylindrical core 41 to form an RFID tag roll 110. An arrangement similar to Fig. 5 is known from WO 01/03188.

As the series of RFID tags 100 is reeled around the core such that the reeled series of RFID tags 100 does not show looseness, the series of RFID tags is reeled with some tension. As reeling is progressing, stress toward the center arises. For this reason, an excessive load is applied to an inside reeled portion of the RFID series 100. In addition, when continuous reeling is made difficult because of the operation timing of a manufacturing apparatus for the RFID series 100, reeling is caused to halt for a certain period to perform an intermittent operation. In this process, because a tension is continuously applied to prevent looseness of the series of RFID tags 100 even during the time when reeling halts, reeling is performed too tightly. Hence, the load applied to an inside reeled portion is further increased.

Accordingly, because stress increases proportionally to an increased amount reeled, breaking of antenna and damage of the IC chip may occur at positions shown by circles in dotted lines in Fig. 5, where IC chips overlap. Therefore, it may be difficult to maintain product functions. This could be prevented by reducing the tension for reeling to relax the stress during the reeling period. However, when the tension is reduced excessively, there may arise the problem that a reel form cannot be maintained due to a reeling collapse. As a way to reduce the stress and simultaneously prevent the rolling collapse, guide walls are provided to hold the series of RFID tags reeled at its both sides. However, their diameter needs to be about twice as large as that of a finished roll for reeling and thereby it is difficult to put the walls in place because of the limited space.

When a defective product is present in a series of RFID tags reeled, there is a need to add a selection process to remove the defective product. Therefore, this substantially affects manufacturing of the RFID tags.

### SUMMARY OF THE INVENTION

In the view of foregoing, the present invention provides a method of reeling the RFID series to give a tension necessary and simultaneously to prevent a product defective from occurring, and an RFID tag roll into which a RFID series is formed by the method of reeling.

According to an aspect of the invention, there is provided a method of reeling a series of RFID tags in which a number of RFID tags each having an antenna and a circuit chip connected to the antenna and performing radio communication with the antenna are formed with a predetermined pitch on a long-belt-like and flexible base, the method including reeling the series of RFID tags around a reel core which reel core is formed by a core material characterized in that a stress absorbing material is wrapped around the core material, the stress absorbing material absorbing a stress produced during the reeling of the series of RFID tags.

It is preferable that the stress absorbing material contracts and deforms in response to the stress produced during the reeling of the series of RFID tags.

In addition, according to another aspect of the invention, an RFID tag roll includes
a series of RFID tags in which a number of RFID tags each having an antenna and a circuit chip connected to the antenna and performing radio communication with the antenna are formed with a predetermined pitch on a long-belt-like and flexible base, and
a reel core around which the series of RFID tags is reeled and which is formed by a core material characterized in that a stress absorbing material is wrapped around the core material, the stress absorbing material absorbing a stress produced during reeling of the series of RFID tags.

According to an aspect of the invention, because the stress absorbing material is provided between the core material and the series of RFID tags, the stress is absorbed by the existence of the stress absorbing material even when the series of RFID tags is reeled with a necessary tension. Therefore, defectives such as breaking of the antenna or damage of the IC chip are avoided.

### BRIEF DESCRIPTION OF THE DRAWINGS

Part (A) and part (B) of
Fig. 1 are respectively a front view and a side cross section both showing an example of RFID tag.
Fig. 2 is a diagram showing a state where the antenna is formed on the base.
Fig. 3 is a process chart showing an IC chip mount process.
Fig. 4 is a process chart showing another IC chip mount process.
Fig. 5 is a diagram showing an RFID tag roll formed by reeling a RFID series.
Fig. 6 is a diagram showing an RFID tag roll formed by reeling a series of RFID tags.

### DETAILED DESCRIPTION OF THE INVENTION

An exemplary embodiment according to the invention will be described with reference to the attached drawings.

In the exemplary embodiment described below, the RFID tag and series of RFID tags themselves are similar to those in the related art described above. Therefore, only differences from the related art will be described, referring to Figs. 1 to 4 and their explanations.

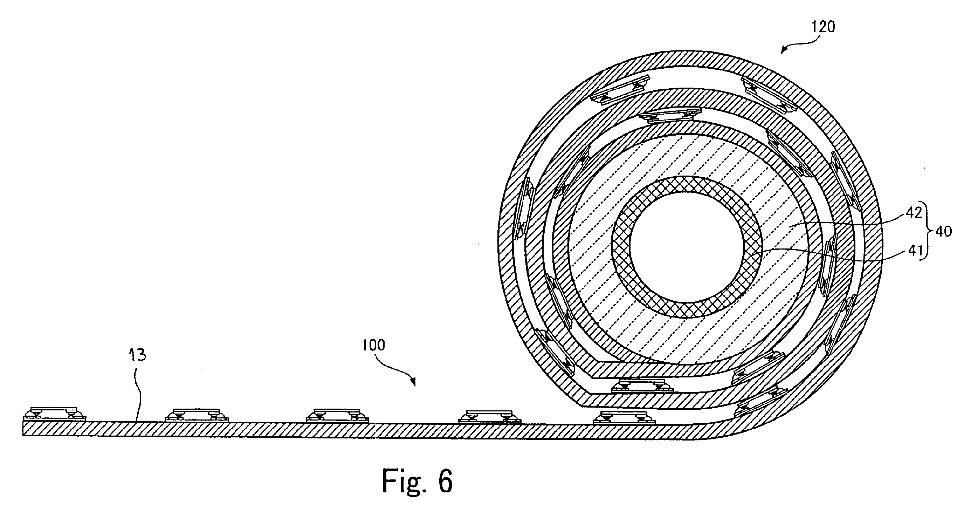

Fig. 6 is a diagram showing an RFID tag roll formed by reeling a series of RFID tags.

The series of RFID tags 100 is reeled around a reel core 40 formed with a core material 41 and a stress absorbing material 42 wrapped around the core material 41 to form the RFID tag roll 120. The core material 41 shown in Fig. 6 has a diameter which is smaller than that of the core material shown in Fig. 5 by a portion for placing the stress absorbing material 42 around the core material 41.

In the exemplary embodiment, as stress absorbing materials, materials can be used such as air buffer material and sponge which are contracted and deformed by an external force.

As described above, when the RFID tag roll 120 is reeled around the reel core 40 formed by the core material 41 and the stress absorbing material 42, a load is applied to an inner reeled portion as reeling is carried out. The stress absorbing material 42 is thereby contracted and deformed to absorb the stress. Therefore, defectives such as breaking of the antenna and damage to the IC chip are prevented.

The stress absorbing material 42 and the core material 41 may be adhered together and be formed integrally. Alternatively, the stress absorbing material 42 may be wrapped around the core material 41 as an independent material, before the series of RFID tags is reeled. The stress produced in an inner reeled portion depends on the length of the series of RFID tags reeled. Therefore, a stress absorbing material 42 having a thickness selected as a function of the length of the series of RFID tags to be reeled may be used.

## Claims

1. A method of reeling a series of RFID tags (100) in which a number of RFID tags each having an antenna and a circuit chip connected to the antenna and performing radio communication with the antenna are formed with a predetermined pitch on a long-belt like and flexible base (13), the method comprising:
reeling the series of RFID tags around a reel core (40) which reel core is formed by a core material (41) **characterized in that** a stress absorbing material (42) is wrapped around the core material (41), the stress absorbing material (42) absorbing a stress produced in reeling the series of RFID tags (100).

2. The method of reeling according to claim 1, wherein the stress absorbing material (42) contracts and deforms in response to the stress produced in reeling the series of RFID tags.

3. An RFID tag roll (120) comprising:
a series of RFID tags (100) in which a number of RFID tags each having an antenna and a circuit chip connected to the antenna and performing radio communication with the antenna are formed with a predetermined pitch on a long-belt-like and flexible base (13); and
a reel core (40) around which the series of RFID tags is reeled and which is formed by a core material (41) **characterized in that** a stress absorbing material (42) is wrapped around the core material, the stress absorbing material absorbing a stress produced in reeling the series of RFID tags.

## Patentansprüche

1. Verfahren zum Spulen einer Serie von RFID-Etiketten (100), in der eine Anzahl von RFID-Etiketten, die jeweils eine Antenne und einen Schaltungschip haben, der mit der Antenne verbunden ist und eine Funkkommunikation mit der Antenne ausführt, mit einer vorbestimmten Teilung auf einer flexiblen Basis (13) gebildet ist, die die Form eines langen Bandes hat, welches Verfahren umfaßt:
Spulen der Serie von RFID-Etiketten um einen Spulenkern (40), welcher Spulenkern aus einem Kernmaterial (41) gebildet ist, **dadurch gekennzeichnet, daß** ein spannungsabsorbierendes Material (42) um das Kernmaterial (41) gewickelt ist, welches spannungsabsorbierende Material (42) um das Kernmaterial (41) gewickelt ist, welches spannungsabsorbierende Material (42) eine Spannung absorbiert, die beim Spulen der Serie von RFID-Etiketten (100) erzeugt wird.

2. Verfahren zum Spulen nach Anspruch 1, bei dem sich das spannungsabsorbierende Material (42) als Reaktion auf die Spannung, die beim Spulen der Serie von RFID-Etiketten erzeugt wird, kontrahiert und deformiert.

3. RFID-Etikettenrolle (120) mit:
einer Serie von RFID-Etiketten (100), in der eine Anzahl von RFID-Etiketten, die jeweils eine Antenne und einen Schaltungschip haben, der mit der Antenne verbunden ist und eine Funkkommunikation mit der Antenne ausführt, mit einer vorbestimmten Teilung auf einer flexiblen Basis (13) gebildet ist, die die Form eines langen Bandes hat; und
einem Spulenkern (40), um den die Serie von RFID-Etiketten gespult wird und der aus einem Kernmaterial (41) gebildet ist, **dadurch gekennzeichnet, daß** ein spannungsabsorbierendes Material (42) um das Kernmaterial gewickelt ist, welches spannungsabsorbierende Material eine Spannung absorbiert, die beim Spulen der Serie von RFID-Etiketten erzeugt wird.

## Revendications

1. Procédé de bobinage d'une série d'étiquettes RFID (100) dans lequel un certain nombre d'étiquettes RFID ayant chacune une antenne et une puce de circuit reliée à l'antenne et effectuant une radiocommunication avec l'antenne est formé avec un pas prédéterminé sur une base flexible en forme de longue courroie (13), le procédé comprenant :
le bobinage de la série d'étiquettes RFID autour d'un noyau de bobine (40), ledit noyau de bobine étant formé par un matériau de noyau (41), **caractérisé en ce qu'**un matériau d'absorption de contraintes (42) est enroulé autour du matériau de noyau (41), le matériau d'absorption de contraintes (42) absorbant une contrainte produite lors du bobinage de la série d'étiquettes RFID (100).

2. Procédé de bobinage selon la revendication 1, dans lequel le matériau d'absorption de contraintes (42) se contracte et se déforme en réponse à la contrainte produite lors du bobinage de la série d'étiquettes RFID.

3. Rouleau d'étiquettes RFID (120) comprenant :
une série d'étiquettes RFID (100) dans laquelle un certain nombre d'étiquettes RFID ayant chacune une antenne et une puce de circuit reliée à l'antenne et effectuant une radiocommunication avec l'antenne est formé avec un pas prédéterminé sur une base flexible en forme de longue courroie (13) ; et
un noyau de bobine (40) autour duquel la série d'étiquettes RFID est bobinée et qui est formé par un matériau de noyau (41), **caractérisé en ce qu'**un matériau d'absorption de contraintes (42) est enroulé autour du matériau de noyau, le matériau d'absorption de contraintes absorbant une contrainte produite lors du bobinage de la série d'étiquettes RFID.
